# EUROPEAN PATENT APPLICATION

(11) **EP 4 270 017 A2**
(43) Date of publication of application: **01.11.2023**
(21) Application number: 23196442.0
(22) Date of filing: 23.10.2018
(51) Int. Cl.: G01R 11/04

(54) **METER CASING WITH TERMINAL COVER LOCKING MECHANISM**

(62) Divisional of application: 18202117.0
(71) Applicant: Kamstrup A/S, 8660 Skanderborg (DK)
(72) Inventor: Hansen, Jan Tejlgaard, 8660 Skanderborg (DK)
(74) Representative: Plougmann Vingtoft a/s

(57) **Abstract**

A casing for an electricity meter including a terminal cover and a locking element is disclosed. The casing provides easy installation closing and sealing of the electricity meter. The casing comprises: a casing base; a casing cover; a terminal cover; and a locking element, where the casing cover is arranged to be mounted on the casing base to create a meter housing, the terminal cover is arranged to be mounted on the meter housing and the locking element is mounted on the terminal cover and adapted to be rotated to engage with the meter housing to create a connection between the terminal cover and the meter housing, whereby the terminal cover is attached to the meter housing. The locking element is finger operable and rotatable between: an open position wherein the terminal cover is detachable from the meter housing, and a locked position wherein the terminal cover is attached to the meter housing. Further, a locking mechanism is arranged to prevent the locking element from being rotated out of the locked position.

## Description

### FIELD OF THE INVENTION

The present invention relates to the field of casings for electricity meters, in particular casings including terminal covers and locking and sealing mechanisms for terminal covers.

### BACKGROUND OF THE INVENTION

The evolution from mechanical electricity meters to the first generations of electronic meters and further on to the smart meters of today has caused significant reduction in: the life time; acceptable price of manufacturing; installation cost of the meters. The smart electricity meters are typically replaced after 10 - 15 years of operation and may be upgraded with new and improved communication technologies during the life time. Thus, price reduction of the meter as well as installation and maintenance costs has become increasingly important. All elements of the electricity meter must thus be optimized, which also includes the meter casing.

Electricity meter casings normally comprise at least two compartments with restricted access. The first compartment is the legal compartment to which access is normally only allowed until a factory verification process has been performed and the legal compartment has been sealed. The second compartment is an installation compartment, from where access to the terminals of the electricity meter is possible. Further the installation compartment may provide access to communication interfaces of the meter and auxiliary modules such as replaceable communication modules and other auxiliary modules such as pulse input and output modules for sub meters. The installation compartment is closed by a cover often called a terminal cover. The terminal cover is normally closed and sealed by the utility company at the end of the installation process in which the electricity meter is installed at a consumption site.

The terminal cover prevents tampering or fraud by changing the wiring of the meters. Further the terminal cover protects unauthorized persons against direct contact to the terminals and wires of the installation, which may cause dangerous situations. From a safety perspective it is important that the terminal cover is not removed unintentionally by unauthorized persons, thus it is often desired that the terminal cover is only removeable by use of tools such as screw drivers.

Closing and sealing of the installation compartment often includes mounting one or more sealing screws and a seal each one of them. Such a procedure requires the use of screwdrivers and sealing tools and is a time-consuming process increasing the installation cost. The use of sealing screws which are normally made from a metal may require a receiving metal element to be included in another part of the meter housing which is often made from a polymer, such a process will add cost to the meter.

### OBJECT OF THE INVENTION

An object of the present invention is to provide an alternative to the prior art. In particular, it may be seen as a further object of the present invention to provide a meter casing that solves the above-mentioned problems by reducing the meter cost and/or enabling simpler installation and maintenance procedures of the meter. A further object of the invention is to provide a tamper resistant and safe meter casing preventing fraudulent as well as unintentionally access to the terminals of the meter and measurement circuits.

### SUMMARY OF THE INVENTION

Thus, the above described object and several other objects are intended to be obtained in a first aspect of the invention by providing a casing for an electricity meter comprising: a casing base; a casing cover; a terminal cover; and a locking element, where the casing cover is arranged to be mounted on the casing base to create a meter housing, the terminal cover is arranged to be mounted on the meter housing and the locking element is mounted on the terminal cover and adapted to be rotated to engage with the meter housing to create a connection between the terminal cover and the meter housing, whereby the terminal cover is attached to the meter housing, characterized in that the locking element is finger operable and rotatable between: an open position wherein the terminal cover is detachable from the meter housing, and a locked position wherein the terminal cover is attached to the meter housing and a locking mechanism is arranged to prevent the locking element from being rotated out of the locked position.

The electricity meter casing is provided to shield the measurement circuits of the electricity meter from the surroundings and to prevent tampering with the electricity meter. This is achieved during the production process of the meter by placing the measurement circuits in the casing base where after the casing cover is attached to the casing base by an irreversible process such as ultrasonic welding, chemical welding, gluing or snap locking mechanisms. The terminal cover is a part of the meter casing mounted on the meter housing to shield the terminals of the meter from the surroundings. By terminals in this regard is understood the power terminals connected to the power lines of the utility distribution network and the wiring of the consumption site. The electricity meter is normally shipped from the factory with the terminal cover mounted on the meter housing, thus the terminal cover must be detached from the meter housing to install the meter at the consumption site and attached to the meter housing after connecting the power terminals of the meter. The casing is advantageous in that attaching and detaching the terminal cover is done easy and quick by rotating the locking element between an open position, a closed position and a locked position by fingers / hand, not requiring the use of any tools.

By the locking element being finger operable is understood that the locking element may be rotated by use of fingers or hand, i.e. no tools are required to rotate the locking element. Rotation of the locking element may require the use of wrist and elbow joints. The locking element may be made more suitable for finger operation by various means such as adapting the shape of the locking element to be easy to hold on to, or by coating the locking element with materials supporting a firm grip. As an alternative the locking element may be equipped with ribs to improve the grip.

The locking element may further be rotatable between a closed position, wherein the terminal cover is attached to the meter housing. This has the advantage the electricity meter may be delivered from the factory with the terminal cover attached to the meter housing, in that the locking element is rotated to the closed position during the production phase. This prevents the terminal cover from unintentionally separating from the meter housing when handled by the installer. In a first step the installer must rotate the locking element to the open position to detach the terminal cover and install the electricity meter by connecting the terminals of the meter to the power lines. In a next step the installer mounts the terminal cover on the meter housing and rotates the locking element to the closed and locked position, whereby the terminal cover is attached and locked to the meter housing in one operation. This has the advantage that mounting and securing the terminal cover is performed in a very simple and time preserving way. When the locking element is in the closed and locked position the locking mechanism prevents the locking element form being rotated out of the locked position and the terminal cover can thus not be detached from the meter housing, which prevents tampering with the installation. Rotating the locking element to the closed and locked position may replace the need for additional mechanical sealing of the terminal cover. When the locking element is rotated to the closed and locked position unauthorized persons are prevented from unintentional contact to the terminals, which may be a mandatory safety requirement to have the meter type approved.

To support maintenance of the meter installation an easy mechanism for detaching the terminal cover after it has been locked is beneficial. Thus, it is advantageous that the locking mechanism comprises a release mechanism arranged for releasing the locking mechanism, to allow the locking element to be rotated out of the locked position. To restrict access to the release mechanism it may be advantageous that the release mechanism is only accessible through a release hole arranged in the locking element or the terminal cover or the casing cover. This has the advantage that the release mechanism may only be operated through the release hole. The release hole may be covered by a sealing sticker or other mechanical sealing means to reveal unauthorized access to the release mechanism. Access to the release mechanism may be further restricted by the dimensions of the release hole. This may be provided if the release hole has dimensions preventing a circular rod with a diameter larger than 10 mm from passing through the hole, to prevent the release mechanism from being finger operable. This has the advantage that the locking element cannot be rotated out of the closed and locked position by hand alone. A tool such as a screw driver must be used to access the release mechanism, which may be a safety requirement. To limit the access to the release mechanism further it may be advantageous to provide a release hole that has dimensions preventing a circular rod with a diameter of 8 mm or even smaller such as 5 mm or 2mm from passing through the hole.

The locking mechanism may be a separate element, however to reduce the number of casing elements it may be advantageous to create the locking mechanism as an integrated part of the locking element and one of the terminal cover, the casing cover or the casing base. This may have the form of a casing wherein the terminal cover has a protrusion or indentation arranged to interact with a protrusion or indentation on the locking element to create the locking mechanism. The protrusion or indentation on the terminal cover may be replaced by a similar protrusion or indentation on the casing cover or casing base. When the locking element is rotated to the locked position the above-mentioned protrusion will enter the above-mentioned indentation to lock the locking element and prevent further rotation of the locking element. To release the locking element to be freely rotated a force must be applied to a least one of the elements containing the indentation or protrusion to make the protrusion exit the indentation. Thus, it is beneficial to provide a casing wherein the locking element has a release hole arranged such that a mechanical force may be applied to a part of the terminal cover through the release-hole to release the locking mechanism.

A casing wherein the locking element is arranged to be rotated more than 15° and less than 345° to shift between the open position and the locked position has the advantage that a strong connection between the terminal cover and the meter housing is provided by the locking element. By connection between the terminal cover and the housing is meant that the locking element extends through the terminal cover into a part of the meter housing which may be the casing cover, casing base or both. The locking element may comprise a rod with a stub which has shape allowing a part of the locking element to pass through a receiving hole in the meter housing when the locking element is in the open position. When the locking element is in the closed or locked position the shape of the rod and the stub of the locking element prevents the same part of the locking element from passing through the receiving hole of the meter housing, in this way the locking element creates a connection between the terminal cover and the meter housing.

To ensure a safe, secure and tamper resistant electricity meter a casing wherein the casing cover has been attached to the casing base in an ultrasonic welding process is advantageous in that the two elements cannot be easily separated without leaving visible marks of the outer surfaces of the elements. An irreversible attaching method has the advantage that it may make further mechanical sealing of the closed meter housing unnecessary. Further ultrasonic welding is a fast and cheap process for mass production. Other processes such as gluing, chemical welding or irreversible click locking mechanisms may be applied as alternatives to ultrasonic welding.

A casing which clearly reveals tampering with the meter by opening the meter casing is beneficial in that fraud may be easily detected by visual inspection of the front of the meter casing. This may be provided by a casing where the locking element has a breaking zone, arranged in a part of the locking element visible from the front of the electricity meter casing. The wheel of the locking element is visible when inspecting the front of the meter casing. Thus, a casing where the breaking zone is located at the centre of the wheel of the locking element is advantageous. To support detection of tampering by visual inspection of the front of the meter casing a casing where the breaking zone is arranged such that detaching the terminal cover from the meter housing, when the locking element is in a closed position, will cause the wheel to disintegrate.

### BRIEF DESCRIPTION OF THE FIGURES

The electricity meter casing according to the invention will now be described in more detail with regard to the accompanying figures. The figures show one way of implementing the present invention and is not to be construed as being limiting to other possible embodiments falling within the scope of the attached claim set.
Figure 1 shows an electricity meter casing in perspective from the front;
Figure 2 shows the electricity meter housing of figure 1 with the terminal cover removed;
Figure 3a shows the terminal cover in perspective from the front;
Figure 3b shows the terminal cover in perspective from the back with the locking element mounted in the mounting hole of the terminal cover;
Figure 4a shows a front view of the electricity meter casing including terminal cover and locking element but without the casing base and the section line A - A;
Figure 4b shows a cut through of the meter casing excluding the casing base according to the vertical line section A - A in figure 4a;
Figure 4c front view of the electricity meter casing including terminal cover and locking element but without the casing base and the section lines E - E and F - F;
Figure 4d shows a cut through of the meter casing excluding the casing base according to the horizontal section line E - E on figure 4c;
Figure 4e shows a cut through of the meter casing excluding the casing base according to the horizontal section line F - F on figure 4c;
Figure 5a and 5b show a perspective view of the locking element from the front and the back, respectively; and
Figure 5c and 5d show a side view and a front view of the locking element, respectively.

### DETAILED DESCRIPTION OF AN EMBODIMENT

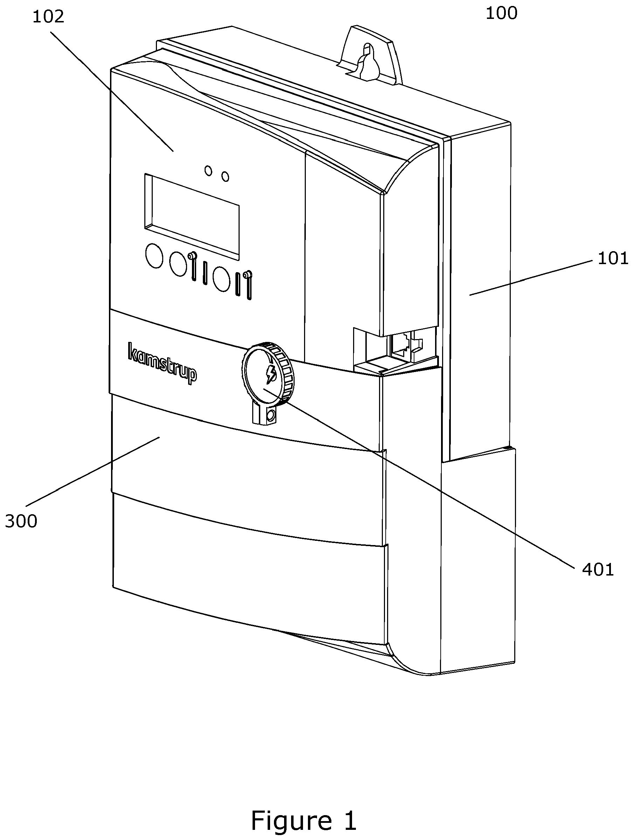

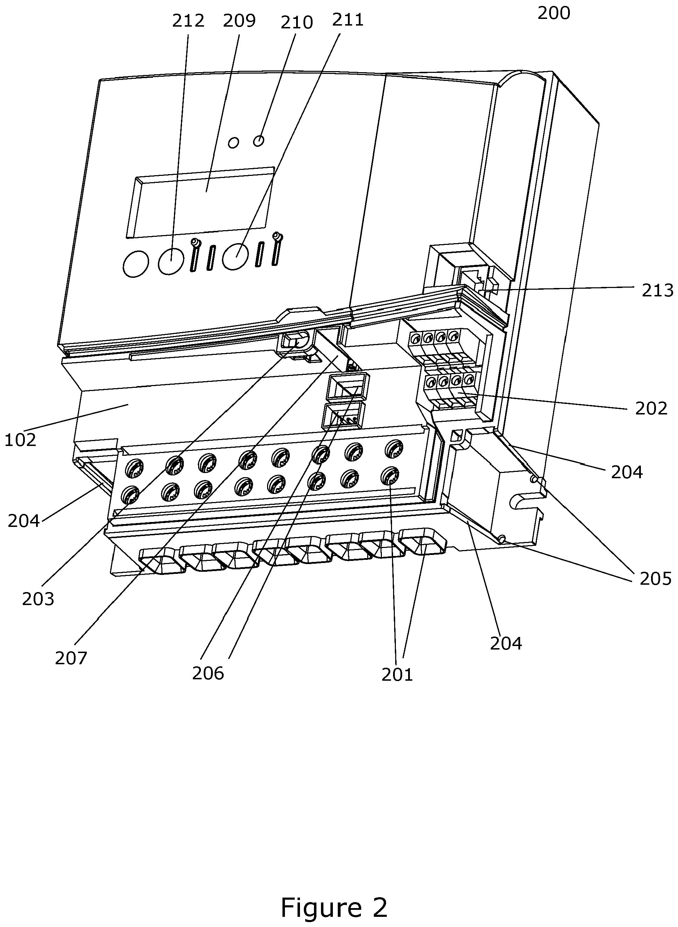

Now referring to fig. 1 an embodiment of an electricity meter casing 100 is described in detail. The casing is especially suitable for electricity utility meters provided to measure the amount of consumed and/or produced electric energy at a consumption site of domestic as well as industrial consumers. The casing is arranged to provide a tamper resistant, easy to install and safe enclosure for an electricity meter. The electricity meter casing comprises a casing base 101, a casing cover 102 and a terminal cover 300. The casing base and casing cover together constitute a meter housing 200 wherein the metrological part of the meter is enclosed, as illustrated in fig. 2. The terminals 201 of the meter are also at least partially arranged inside the meter housing but accessible from the outside for connection of power lines. Further elements may be arranged inside the meter housing such as communication modules for reading of the meter, breakers for disconnecting the consumption site, input terminals 202 for sub meters etc. The terminal cover 300 is mounted on the meter housing 200 to create a complete meter casing 100. The terminal cover is shielding the terminals 201 and other interfaces from unauthorized access to avoid risk of unintended contact to the terminals and fraudulent modifications of the installation. The terminal cover 300 itself or the space between the meter housing and the terminal cover may provide a module compartment 311 for installation of auxiliary modules e.g. communication modules. The terminal cover is attached to the meter housing by use of a locking element 401. The locking element is finger-operable, which means it may be operated by hand without the use of any tolls. The locking element controls the attachment and detachment of the terminal cover 300 to the meter housing 200 in that the locking element may be shifted between: an open position, where the terminal cover is detachable from the meter housing; one or more closed positions, where the terminal cover is attached to the meter housing; a closed and locked position, where the terminal cover is attached to the meter housing and a locking mechanism prevents the locking element from being shifted out of the closed and locked position. An installer or service technician may end an installation or service phase by installing the terminal cover and by hand shift the locking element from the open position to the closed and locked position, without use of ay tools. Thereby the meter casing is closed safely and secured in one simple and time saving process not requiring the use of any tools.

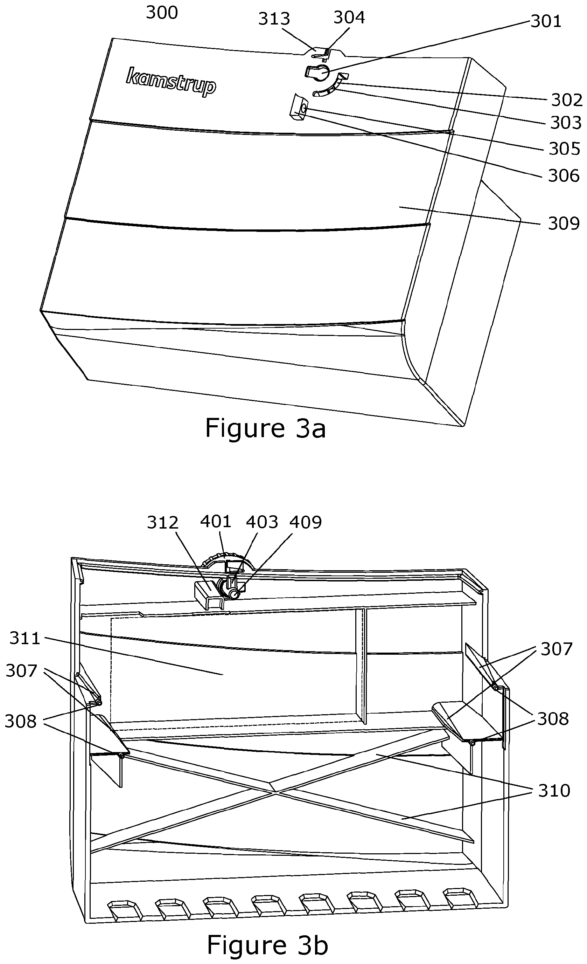

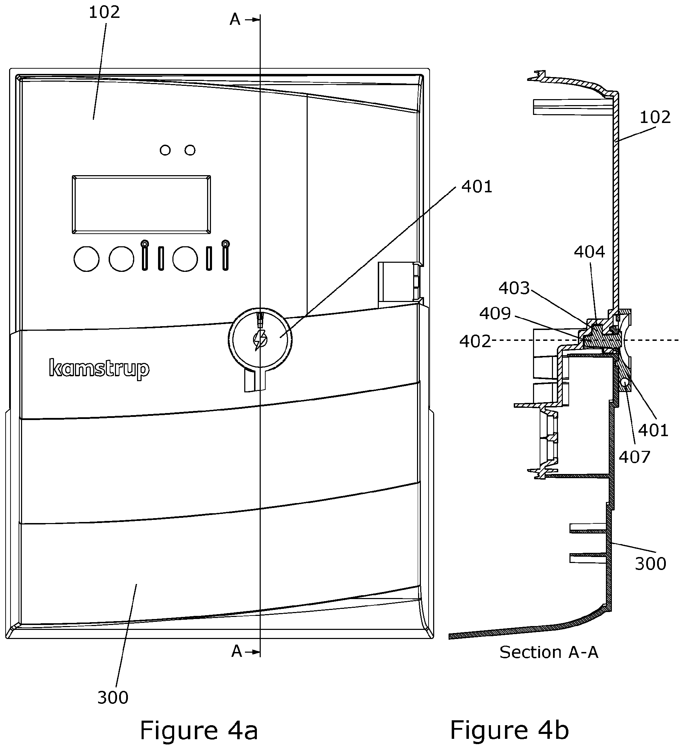

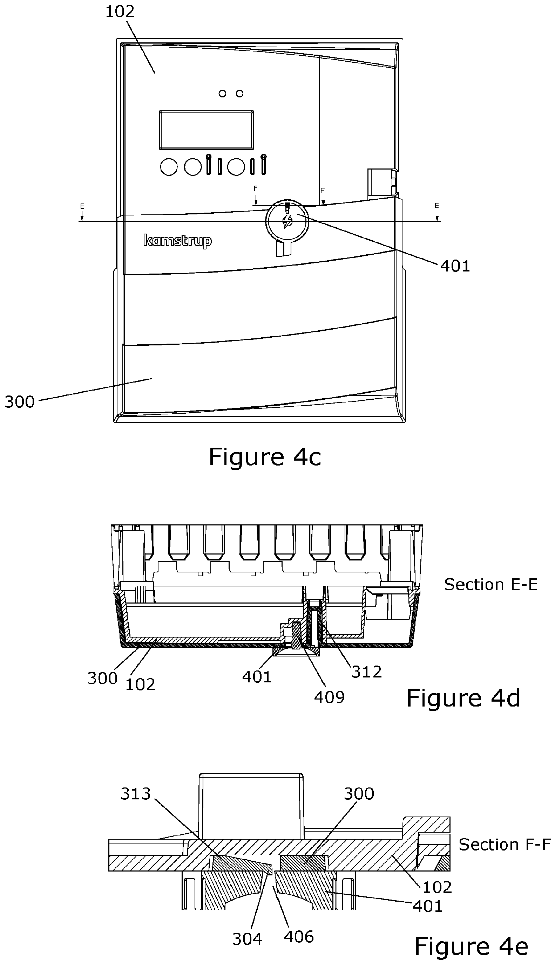

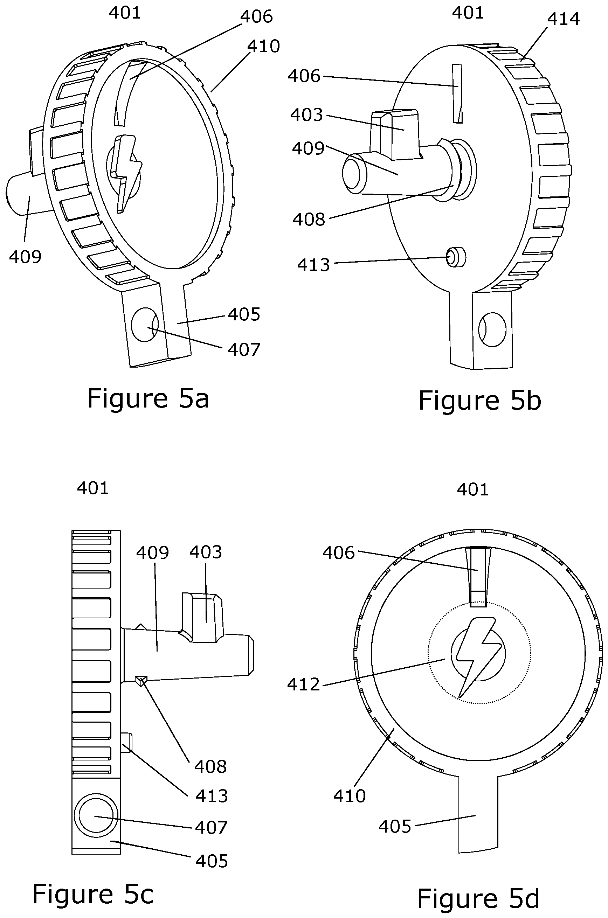

Now referring to fig. 4a - 4e and fig. 5a - 5d the locking element 401 and its interaction with the terminal cover 300 and the meter housing 200 is illustrated in detail. The locking element 401 is mounted in a mounting hole 301 in the terminal cover 300, fig. 3a. The locking element comprises a rod 409 with a collar 408. When the locking element is mounted on the terminal cover as illustrated in fig. 3b, the rod extents through the mounting hole 301 in the terminal cover 300 and the collar 408 together with the mounting hole 301 in the terminal cover creates a click lock function to prevent the locking element from falling out of the mounting hole 301. The locking element is arranged to rotate around a centre axis 402 of the rod 409, when mounted in the terminal cover, see fig 4b. With the terminal cover 300 including the locking element 401 mounted on the meter housing 200 the rod 409 of the locking element extends through the terminal cover 300 into a receiving hole 203 fig. 2, in the casing cover 102. The locking element is shifted between open and closed positions by rotation of the locking element. A protrusion 403 on the rod 409 of the locking element is by rotation of the locking element shifted into a recess 404 inside the receiving hole 203 of the casing cover, whereby the locking element is in a closed position and the terminal cover is attached to the meter housing. The locking element 401 is finger operable in that it may be rotated by applying a torque to its outer surfaces by use of fingers / hand. To support application of a torque to the locking element by fingers, a stub 405 is arranged on the locking element. Alternatively, the locking element may be differently shaped to support rotation by fingers, such different shapes could be any polygon with side lengths sufficiently large to support operation by fingers. Another alternative shaping of the locking element is to provide wings on the activator, as known from a wingnut. Further the locking element may have ribs 414 to support a sufficient grip to rotate the locking element by fingers.

The rotation of the locking element 401 is limited to 90° by a recess 302 in the terminal cover shaped as a part of a circular arc corresponding to 90°. When the locking element is mounted on the terminal cover 300 a protrusion 413 of the locking element protrudes into the recess 302 in the terminal cover, whereby the rotational movement of the locking element is limited to 90°. In alternative embodiments the rotational movement of the locking element may be larger in that the recess 302 spans a greater part of a circular arc such as up to 345° but below 360°, since a rotation of 360° would make the locking element re-enter the open position. The recess 302 does not extent all the way through the terminal cover 300. The protrusion 413 is longer than the depth of the recess 302 and friction between the terminal cover and the locking element will occur when rotating the locking element. Thus, a first torque must be applied to the locking element to overcome the friction and rotate the locking element. The recess 302 in the terminal cover has three positions where the recess is made deeper than elsewhere, to create resting positions for the locking element. To rotate the locking element out of such a resting position a second and larger torque is required, this is still possible by use of fingers. The first resting position is at the open position (0° rotation), the second resting position 303 is positioned where the locking element is rotated 45° which is a closed position and the last resting position is positioned at 90° which is the closed and locked position. The resting positions may be at any other positions not exceeding 345° e.g. 0°, 90° and 180°, respectively.

The meter casing further comprises a locking mechanism, as illustrated in detail in fig. 4e. The locking mechanism automatically locks the locking element 401, to prevent further rotation, when the locking element has entered the closed and locked position. The locking mechanism is provided by a protrusion 304 on the terminal cover and a recess 406 in the surface of the locking element facing the terminal cover. When the locking element 401 is shifted by rotation into the closed and locked position the protrusion 304 will enter the recess 406 and further rotation of the locking element is not possible. The protrusion 304 is placed on an appendix 313 of the terminal cover 300 to provide a spring function. The recess 406 extends all the way through the locking element and is accessible from the front surface of the locking element. Thereby the protrusion 304 of the terminal cover is accessible from the front surface of the of the locking element 401 through the recess 406. Thereby a release mechanism is realized, in that the protrusion 304 of the terminal cover 300 may be pushed out of the recess 406, by applying a force to the protrusion 304 through the recess 406, whereby the locking element 401 may again be freely rotated out of the closed and locked position. The recess 406 is small having dimensions such as e.g. 2x8 mm, in this way the release mechanism cannot be activated by fingers, a tool such as screw driver must be used to activate the release mechanism. As an alternative the recess 406 in the locking element may extent into but not all the way through the locking element. In this way it is inaccessible when the locking element is mounted on the terminal cover and reopening the terminal cover would require a destructive action. Thereby the locking element will have the function of a seal

As a further or alternative security mechanism to ensure that locking element is not shifted out of the closed position, the locking element is provided with a through going hole 407 for mounting a mechanical sealing mechanism (not shown). A corresponding through going hole 305 in a protrusion 306 on the terminal cover 300 is provided to support the sealing. When the mechanical seal is mounted the locking element cannot be shifted without breaking the mechanical seal. The locking element may in this way become a sealing element creating a sealing between the terminal cover 300 and the meter housing 200.

The locking element 401 is constructed with a breaking zone 412 which is an area of smallest material thickness around the centre of the wheel 410 where the rod 409 is extending from the wheel 410 of the locking element 401. In case of an attempt to detach the terminal cover without first shifting the locking element to an open position the part of the locking element breaking will be the wheel 410 disintegrating in such a way that it will be visible by inspecting the locking element 401 from the front. This is in contrary to a situation where the weakest point of the locking element is the point connecting the protrusion 403 and the rod 409 or a part of the meter housing, in that case a successful attempt to break the meter casing open might not be visible from an external view of the assembled meter casing.

The casing base 101 is made by a polymer suitable for being ultrasonic welded to the casing cover 102. The ultrasonic welding may be performed along all interfacing edges between the casing base and casing cover or only along selected sections. The ultrasonic welding shall ensure that the two elements become one inseparable meter housing 200 protecting the meter from being tampered with, without leaving visible signs of opening the meter. Thus, the welding may preferably cover more than 50% of the total length of interfacing edges. By ultrasonic welding the casing cover102 to the casing base 101, a meter housing 200 with a very high mechanical integrity is obtained. As an alternative to ultrasonic welding a chemical welding process may be applied. As an alternative to welding, the casing base and casing cover may be attached to each other by any other suitable means which make separation of the items impossible without leaving visible marks such as an irreversible clicking locking mechanism or glue. The casing base has assembly fins 204 and holes 205 in corner positions to receive corresponding assembly fins 307 and protrusions 308 on the terminal cover. This is to secure multipoint attachment of the terminal cover when mounted on the meter housing. The assembly fins holes and protrusions ensure a rigid construction of the assembled electricity meter casing, which prevents unauthorized access to the meter parts covered by the terminal cover when the locking element is in a closed position.

The casing cover 102 is made from polymer and provided with an interfacing surface suitable for ultrasonic welding to the casing base 101. The casing cover has a display opening 209, an infrared communication port opening 211 and light emission openings 210 which all may be covered by a light transparent element (not shown). Holes for buttons 212 are provided to enable user interaction with the meter inside the meter casing. Further holes for various connectors are provided in the casing cover such as a RJ45 connector 213, input terminals 202, 206, antenna connectors (not shown). Some connectors are covered by the terminal cover, when mounted, while others are accessible without removing the terminal cover. Finally holes for operating the terminals 201 are provided to connect the meter to the power lines of the utility distribution network and the consumption site. When the connectors, buttons and transparent elements are mounted the internal of the meter housing 200 is inaccessible through the openings in the casing cover.

Now referring to fig. 3a and 3b the terminal cover is discussed in detail. The terminal cover 300 is made from a polymer. Parts of the terminal cover may be transparent or semi-transparent to create a window 309 for visual inspection of e.g. the terminals 201 from the outside. The terminal cover is provided with rigidity fins 310 on its inner surface to increase rigidity of the construction. Further a brace 312 is added to the inner surface of the terminal cover close to the mounting hole 301 for the locking element 401. When the terminal cover is mounted on the meter housing 200 the brace 312 extents into a receiving hole 207 of the casing cover 102 to increase rigidity in the area around the locking element. The previously mentioned corresponding assembly fins 307, holes 205 and protrusions 308 combined with the rigidity fins 310 and the brace 312 ensures a high rigidity of the assembled meter casing preventing access to elements shielded by the terminal cover when the locking element 401 is in a closed position. A module compartment 311 is incorporated in the terminal cover to accommodate auxiliary modules. Electrical connection between the auxiliary modules and the electricity meter is ensured by providing openings 206 in the casing cover 102 to enable connections between an auxiliary module PCB connector and a connector of the electricity meter. The meter casing is arranged to provide a tight enclosure protecting the meter and the connection to the terminals when the terminal cover is attached, full filling the tightness class IP52 or better, measured according to IEC standard 60529.

Preferably all parts of the meter casing are made from a polymer. However any part may be made from alternative materials such as metal to increase mechanical strength.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A casing for an electricity meter comprising:
- a casing base (101);
- a casing cover (102);
- a terminal cover (300); and
- a locking element (401),
where the casing cover is arranged to be mounted on the casing base to create a meter housing (200), the terminal cover is arranged to be mounted on the meter housing and the locking element is mounted on the terminal cover and adapted to be rotated to engage with the meter housing to create a connection between the terminal cover and the meter housing, whereby the terminal cover is attached to the meter housing,
**characterized in that**
the locking element (401) is finger operable and rotatable between:
- an open position wherein the terminal cover (102) is detachable from the meter housing (200), and
- a locked position wherein the terminal cover is attached to the meter housing and a locking mechanism is arranged to prevent the locking element (401) from being rotated out of the locked position.

2. A casing according to any of the preceding claims, wherein the locking element (401) further is rotatable between a closed position, wherein the terminal cover (300) is attached to the meter housing (200).

3. A casing according to any of the preceding claims, wherein the terminal cover (300) has a protrusion (304) or indentation arranged to interact with a protrusion or indentation (406) on the locking element (401) to create the locking mechanism.

4. A casing according to any of the preceding claims, wherein the locking mechanism comprises a release mechanism arranged for releasing the locking mechanism, to allow the locking element (401) to be rotated out of the locked position.

5. A casing according to claim 4, wherein the release mechanism is only accessible through a release hole (406) arranged in the locking element (401) or the terminal cover (300) or the casing cover(102).

6. A casing according to claim 5, wherein the release hole (406) is arranged such that a mechanical force may be applied to a part of the terminal cover through the release hole to release the locking mechanism.

7. A casing according to claims 5 or 6 wherein the release hole has dimensions preventing a circular rod with a diameter larger than 10 mm from passing through the release hole, to prevent the release mechanism from being finger operable.

8. A casing according to any of the preceding claims, wherein the locking element (401) is arranged to be rotated more than 15° and less than 345° to shift between the open position and the locked position.

9. A casing according to any of the preceding claims, wherein the casing cover (102) has been attached to the casing base (101) in an ultrasonic welding process.

10. A casing according to any of the preceding claims, where the locking element (401) has a breaking zone (412), arranged in a part of the locking element visible from the front of the electricity meter casing.

11. A casing according to claim 10, where the breaking zone (412) is located at the centre of a wheel (410) of the locking element (401).

12. A casing according to claims 10 or 11, where the breaking zone (412) is arranged such that detaching the terminal cover (300) from the meter housing (200), when the locking element (401) is in a closed position, will cause the wheel (410) to disintegrate.
